# EUROPEAN PATENT APPLICATION

(11) **EP 4 832 336 A1**
(43) Date of publication of application: **28.10.2026**
(21) Application number: 24908063.1
(22) Date of filing: 18.12.2024
(51) Int. Cl.: H02N 2/18, H02N 11/00, H10N 30/30

(54) **ENERGY HARVESTING DEVICE**

(30) Priority: 18.12.2023 KR 20230185220
(71) Applicant: POSCO Holdings Inc., Pohang-si, Gyeongsangbuk-do 37859 (KR); Research Institute of Industrial Science & Technology, Pohang-si, Gyeongsangbuk-do 37673 (KR); POSTECH Research and Business Development Foundation, Pohang-si, Gyeongsangbuk-do 37673 (KR)
(72) Inventor: RHO, Jun-Suk, Pohang-si, Gyeongsangbuk-do 37673 (KR); LEE, Geon, Pohang-si, Gyeongsangbuk-do 37673 (KR)
(74) Representative: Pfenning, Meinig & Partner mbB
(86) International application number: PCT/KR2024/020604
(87) International publication number: WO 2025/135780

(57) **Abstract**

An embodiment of the present invention provides an energy harvesting device including: an object; a propagation area disposed in a first area of the object; a coherence area disposed in a second area of the object and having a thickness varying along a width direction of the object; and an energy conversion unit disposed in the coherence area and converting elastic wave energy into electrical energy.

## Description

### Technical Field

The present disclosure relates to an energy harvesting device.

### Background Art

A metalens refers to a structure or design capable of controlling and steering a propagation path of waves by adjusting the shape and material of a lens comprised of an array of periodic unit structures. The field of metalenses, which has been actively studied in the areas of light and electromagnetic waves, has recently been extended to the control of elastic waves, and various wave phenomena have been realized by applying refractive index distributions such as those of Maxwell fisheye lenses, Luneburg lenses, and Eaton lenses.

Recently, among methods for controlling elastic waves, a design method for a Michaelian lens has been proposed in which the refractive index distribution of a Maxwell fisheye lens is transformed based on conformal mapping theory. The Michaelian lens is designed to focus planar waves on a specific focal point. In order to implement such a refractive index distribution in a physical structure, conventional approaches have expressed the refractive index by gradually varying geometric parameters of pillars attached to a thin plate or holes formed in a thin plate. However, these approaches not only reduce wave transmission efficiency due to high impedance, but also lead to undesired scattering of waves, thereby changing wave characteristics.

To overcome the above-described disadvantages, the present disclosure proposes an energy harvesting device in which the refractive index distribution of the Michaelian lens is combined with Kirchhoff-Love plate theory, such that the effective refractive index is determined solely by the thickness of the plate. Accordingly, waves of all frequencies may be focused at a same focal point, independent of frequency. Furthermore, there is a need for development of an energy harvesting device capable of improving energy harvesting performance by inducing a high strain field in a piezoelectric element through elastic wave energy concentrated on the same focal point.

### Summary of Invention

### Technical Problem

An aspect of the present disclosure is to provide a high-performance energy harvesting device capable of extracting electrical energy over a wide frequency range by being configured to concentrate elastic wave energy on the same location (focal point) even when the frequency is changed.

### Solution to Problem

According to an aspect of the present disclosure, an energy harvesting device includes: an object; a propagation area disposed in a first area of the object; a focal area disposed in a second area of the object and having a thickness varying in a width direction of the object; and an energy conversion unit disposed in the focal area and converting elastic wave energy into electrical energy.

The propagation area may be flat in shape with a uniform thickness in the width direction.

The focal area may have a concave portion that is concave inwardly from an upper surface of the object.

The thickness may gradually decrease from one end of the concave portion to the other end with respect to the width direction, and then gradually increase again.

The concave portion may have a shape symmetrical with respect to a center of the concave portion.

The concave portion may extend from one end of the focal area to the other end in a longitudinal direction of the object.

The elastic wave energy may be concentrated on a focal point, and the concentration location may be disposed within the concave portion, but may be fixed regardless of a frequency of the elastic wave energy.

The focal point may be determined using an effective refractive index of the object, and the effective refractive index may be defined by the following Equation, ${n}_{z}^{eff} \left(x, y\right) = \sqrt{\frac{{h}_{max}}{h \left(x\right)}}$ wherein, in the above Equation, n_{z}^{eff} represents the effective refractive index, h(x) represents a thickness of the focal area, and hₘₐₓ represents a maximum thickness of the focal area.

In the above focal area, a refractive index gradient of the elastic wave energy may be formed based on the change in thickness in the width direction.

The refractive index gradient may correspond to a refractive index distribution of a Michaelian lens.

The elastic wave energy may be applied to one point on the propagation area, and the focal point may be spaced apart from the one point by a predetermined distance in the longitudinal direction of the object.

The energy conversion unit may include a piezoelectric element, and may be connected to the focal point to extract a voltage using the concentrated elastic wave energy.

### Advantageous Effects of Invention

According to an aspect of the present disclosure, an energy harvesting device may concentrate elastic wave energy on a specific location on a plate to induce a high strain field in a piezoelectric element of an energy conversion unit, thereby improving energy harvesting performance.

In addition, the energy harvesting device is configured such that an effective refractive index is determined solely by a thickness of a plate, whereby all elastic waves are concentrated on the same focal point regardless of frequency, thereby enabling implementation of piezoelectric energy harvesting not only in a high-frequency range but also in a low-frequency range. By doing so, by overcoming the disadvantages of conventional piezoelectric energy harvesting devices which are limited to the high-frequency range and by simultaneously implementing piezoelectric energy harvesting even in the low-frequency range to enable applications in real life, the piezoelectric energy harvesting device may be applied in various signal processing devices such as the Internet of Things, wireless communication, and structural safety monitoring.

### Brief Description of Drawings

FIG. 1 is a perspective view schematically illustrating an energy harvesting device according to an example embodiment of the present disclosure.
FIG. 2 is a cross-sectional view taken along line A1-A1' of FIG. 1.
FIG. 3 is a cross-sectional view taken along line A2-A2' of FIG. 1.
FIG. 4 is a diagram schematically illustrating an energy harvesting device and a supply unit connected thereto according to an example embodiment of the present disclosure.
FIG. 5a is a diagram schematically illustrating a refractive index distribution of a Maxwell fisheye lens.
FIG. 5c is a diagram illustrating a dimension before transformation (left) and a dimension after transformation (right), respectively, by conformal mapping theory.
FIG. 6 is a diagram schematically illustrating a refractive index distribution of a Michaelian lens transformed from the refractive index distribution of the Maxwell fisheye lens of FIG. 5a by applying the conformal mapping theory.
FIG. 7a is a graph showing a band structure according to a thickness of a focal area.
FIG. 7b is a graph showing an effective refractive index according to the thickness of the focal area.
FIGS. 8a through 8c are graphs showing the results of elastic wave energy concentrated on a focal point according to different frequencies.
FIGS. 9a through 9c are graphs showing the results of elastic wave energy detection at a shear portion of the focal area and the focal point, respectively, according to different frequencies.
FIGS. 10a through 10c are graphs showing the results of voltage extraction at the focal point of the focal area and at other locations of the focal area, respectively, according to different frequencies.
FIGS. 11a through 11c are graphs showing a power measurement result at the focal point of the focal area and at other locations of the focal area, respectively, according to different frequencies.

### Best Mode for Invention

Hereinafter, the example embodiments will be described in detail with reference to the accompanying drawings so that they can be easily practiced by those skilled in the art to which the present disclosure pertains. However, in describing example embodiments of the present disclosure, detailed descriptions of well-known functions or constructions will be omitted so as not to obscure the description of the present disclosure with unnecessary detail. In addition, like or similar reference numerals denote parts performing similar functions and actions throughout the drawings. In addition, in this specification, the terms such as "top," "upper portion," "upper surface," "bottom," "lower portion," "lower surface," and "side surface" are based on the drawings and may vary depending on a direction in which components are arranged in practice.

A case in which any one part is connected with the other part includes a case in which the parts are directly connected with each other and a case in which the parts are indirectly connected with each other with other components interposed therebetween. In addition, a phrase 'including any component' will be understood to imply the inclusion of other components rather than the exclusion of other component, unless explicitly described otherwise.

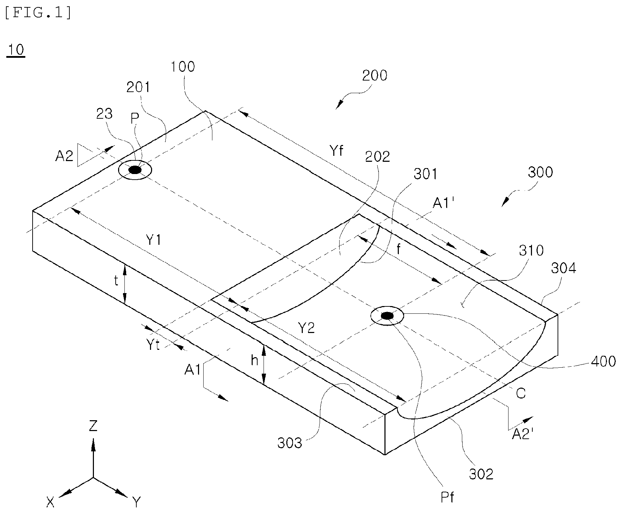

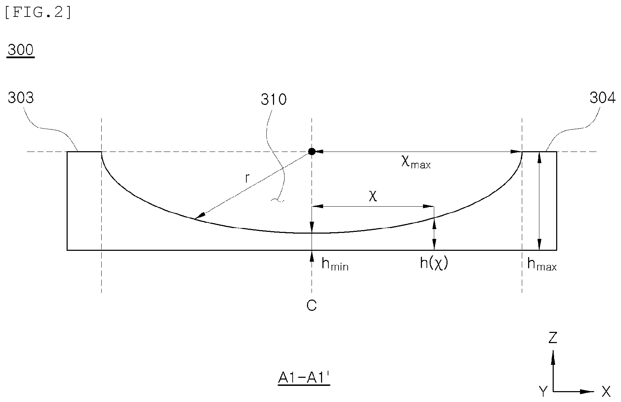

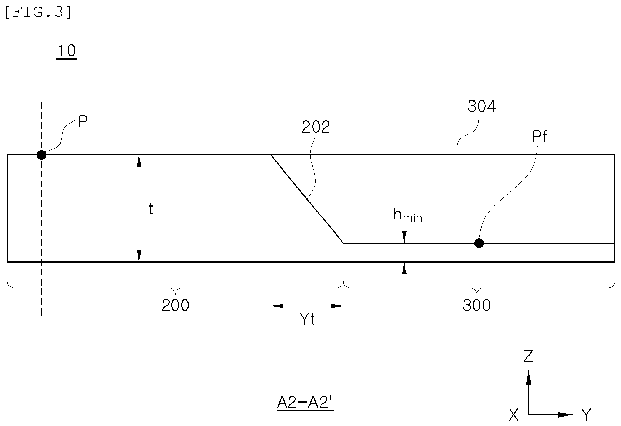

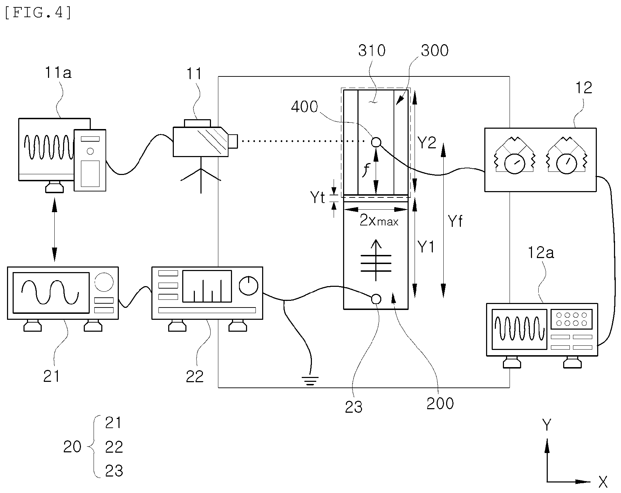

FIG. 1 is a perspective view schematically illustrating an energy harvesting device according to an example embodiment of the present disclosure. FIG. 2 is a cross-sectional view taken along line A1-A1' of FIG. 1. FIG. 3 is a cross-sectional view taken along line A2-A2' of FIG. 1. FIG. 4 is a diagram schematically illustrating an energy harvesting device and a supply unit connected thereto according to an example embodiment of the present disclosure.

Referring to FIGS. 1 through 3, an energy harvesting device 10 may be a device for concentrating elastic wave energy applied to an object 100 into a specific area and then converting the elastic wave energy into electrical energy and extracting the electrical energy. In this case, the energy harvesting device 10 may include the object 100, a propagation area 200, a focal area 300, and an energy conversion unit 400.

The object 100 may be formed in the form of a thin plate. In this case, the object 100 may be made of various metal materials. For example, the object 100 may be a thin plate made of aluminum.

The propagation area 200 may be an area to which elastic wave energy is applied by a transducer 23. The propagation area 200 may be formed in a first area of the object 100. For example, the propagation area 200 may be a front area of the object 100 based on a direction in which the applied elastic wave energy propagates or a longitudinal direction Y of the object 100.

The propagation area 200 may be connected to a second area of the object 100. In this case, the second area of the object 100 is the area where the focal area 300 is formed, and may be a rear area of the object 100 based on a direction Y in which the elastic wave energy propagates. In this case, the rear end portion 202 of the propagation area 200 may come into contact with a shear portion 301 of the focal area 300, and the contacted portion is referred to as a boundary surface. Accordingly, the propagation area 200 and the focal area 300 may be continuous in the longitudinal direction Y of the object 100.

A rear end portion 202 of the propagation area 200 may be inclined at a predetermined angle. More specifically, the rear end portion 202 of the propagation area 200 may be inclined such that a thickness t decreases uniformly as it moves from the propagation area 200 to the focal area 300, as illustrated in FIG. 3. Due to this rear end portion 202 of the propagation area 200, a sudden change in structure (e.g., thickness) may not occur at the boundary between the propagation area 200 and the focal area 300. By doing so, when the elastic wave moves from the propagation area 200 to the focal area 300, the propagation of the elastic wave may be prevented from being obstructed by the change in structure at the above-described boundary. Meanwhile, the rear end portion 202 of the propagation area 200 may be formed with a predetermined length Yt. In this case, the length Yt of the above-described rear end portion 202 may be a length that may be arbitrarily set.

The propagation area 200 may have a uniform thickness t in a width direction X. In addition, the propagation area 200 may have a uniform thickness t throughout the entire above-described first area of the object 100 by forming a uniform thickness t along the length direction Y as well. Accordingly, the propagation area 200 may be in the shape of a plate.

After being applied to the propagation area 200, the elastic wave energy may be concentrated on a point Pf in the focal area 300 as it propagates along the above-described propagation direction Y.

The focal area 300 may be in a shape where a thickness h at least partially varies. More specifically, the thickness h of the focal area 300 may vary in the width direction X of the object 100.

The focal area 300 may have a maximum thickness hₘₐₓ at two side end portions 303 and 304 in the width direction X. In this case, the thickness h of the focal area 300 may gradually decrease from one end 303 of the two side end portions 303 and 304 toward a center C. Accordingly, the focal area 300 may have a minimum thickness hₘᵢₙ at the center C. Furthermore, the thickness h of the focal area 300 may gradually increase again from the above-described center C toward the other side end 304 of the two side end portions 303 and 304. Accordingly, the focal area 300 may be provided with a concave portion 310 that is formed inwardly on its upper surface.

In an example embodiment, the concave portion 310 may have a shape in which a radius of curvature r varies in the width direction X. In this case, a maximum radius of curvature xₘₐₓ may be maximum at the two side end portions 303 and 304 of the concave portion 310. The maximum radius of curvature xₘₐₓ may be half the width 2xₘₐₓ of the concave portion 310. A radius of curvature R of the concave portion 310 decreases from the two side end portions 303 and 304 toward the center C, so that the radius of curvature r may be minimum at the center C. Accordingly, when viewed from the side direction (e.g., a direction parallel to a ZX plane), a cross-sectional shape of the concave portion 310 may be a shape curved downward.

The concave portion 310 may be extended parallel to the above-described propagation direction (or length direction) Y. More specifically, the concave portion 310 may be extended from the shear portion 301 of the focal area 300 to the rear end portion 302 of the focal area 300 along the length direction Y of the object 100.

Meanwhile, the drawings illustrate only that the two side end portions 303 and 304 of the focal area 300 have a flat shape with a uniform thickness hₘₐₓ, and that a thickness h of the focal area 300 varies between the two side end portions 303 and 304; however, the present disclosure is not limited thereto.

The energy conversion unit 400 may convert elastic wave energy into electrical energy. As an example, the energy conversion unit 400 may include an energy conversion element such as a piezo element. In this case, the energy conversion element may be a device that has the effect of generating voltage when deformed by stress.

The energy conversion unit 400 may be connected to the focal area 300. More specifically, the energy conversion unit 400 may be connected to a focal point Pf within the focal area 300. In this case, the focal point Pf is a point where the elastic wave energy propagated into the focal area 300 converges, and specific details thereof will be described below.

Referring to FIG. 4, a power supply unit 20 may be connected to the energy harvesting device 10. For example, the power supply unit 20 may include a function generator 21, a power amplifier 22, and a transducer 23. In this case, an electrical signal of a specific frequency input from the function generator 21 may pass through the amplifier 22 and noise may be removed. Subsequently, the elastic wave may be converted at the transducer 23 and supplied to the energy harvesting device 10. In this case, the transducer 23 may be connected to the shear portion 201 of the first area of the object 100, that is, the propagation area 200. The elastic wave applied through the transducer 23 may propagate through the object 100.

The elastic wave propagates along the object 100 in the longitudinal direction Y and may be concentrated on the focal point Pf within the focal area 300. The energy conversion unit 400 is connected to the location f to convert the concentrated elastic wave energy into electrical energy (e.g., voltage). In this case, the elastic wave energy concentrated on the focal point Pf may be detected by a detector 11, such as a scanning LDV. In addition, the detection result of the detector 11 is transmitted to a control unit 11a and may be displayed and verified through a display device.

Meanwhile, the energy conversion unit 400 may include a resistance substituter 12 and an oscilloscope 12a. In this case, the voltage extracted by the energy conversion unit 400 may be controlled by adjusting the resistance using the resistance substituter 12. Furthermore, the resistance substituter 12 may be used to calculate the optimal resistance in the relationship with power according to the extracted voltage. In addition, the voltage state according to the change in resistance value by the resistance substituter 12 may be checked using the oscilloscope 12a.

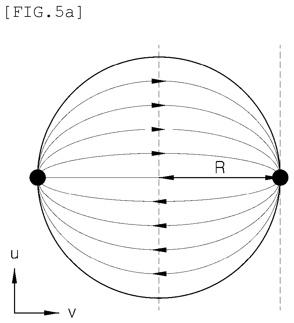

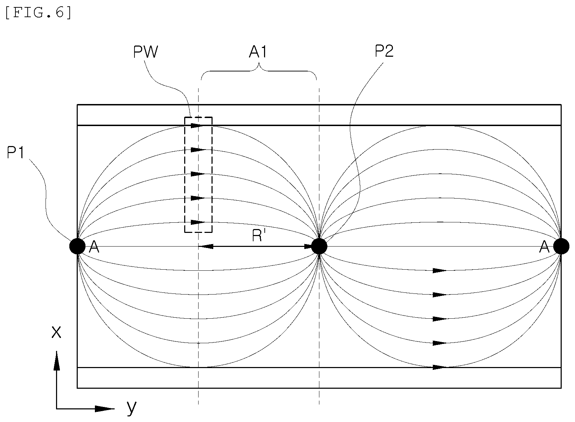

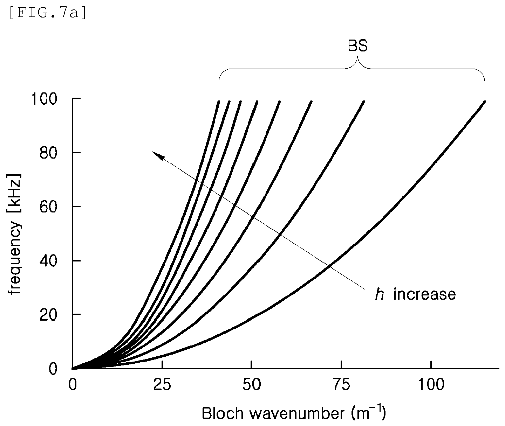

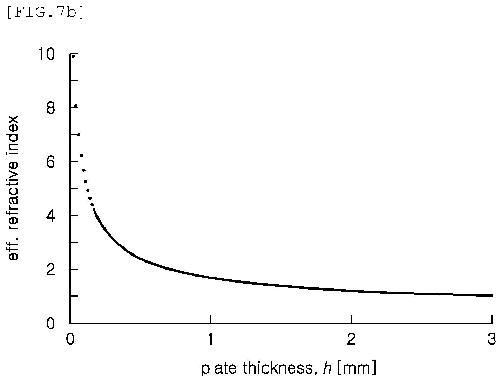

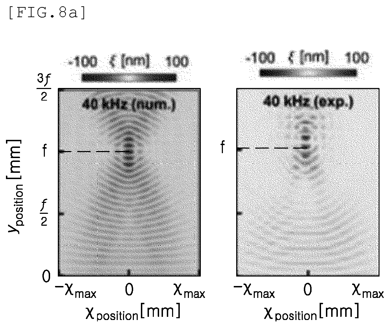

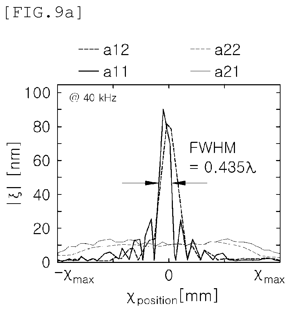

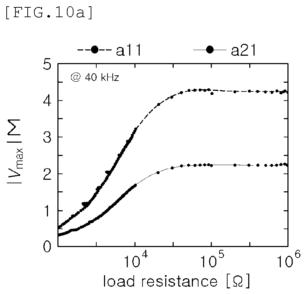

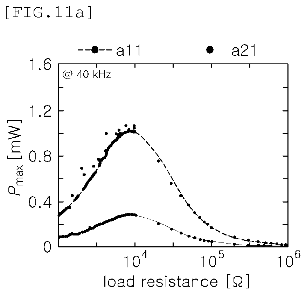

FIG. 5a is a diagram schematically illustrating a refractive index distribution of a Maxwell fisheye lens, and FIG. 5c is a diagram illustrating a dimension before transformation (left) and a dimension after transformation (right), respectively, by conformal mapping theory. FIG. 6 is a diagram schematically illustrating a refractive index distribution of a Michaelian lens transformed from the refractive index distribution of the Maxwell fisheye lens of FIG. 5a by applying the conformal mapping theory. FIG. 7a is a graph showing a band structure according to a thickness of a focal area, and FIG. 7b is a graph showing an effective refractive index according to the thickness of the focal area. FIGS. 8a through 8C are graphs showing the results of elastic wave energy concentrated on a focal point according to different frequencies. FIGS. 9a through 9c are graphs showing the results of elastic wave energy detection at a shear portion of the focal area and the focal point, respectively, according to different frequencies. FIGS. 10a through 10c are graphs showing the results of voltage extraction at the focal point of the focal area and at other locations of the focal area, respectively, according to different frequencies. FIGS. 11a through 11c are graphs showing the power measurement result at the focal point of the focal area and at other locations of the focal area, respectively, according to different frequencies.

Referring to FIGS. 1 through 11, a method of condensing elastic wave energy and converting the elastic wave energy into electrical energy and extracting the elastic wave energy using the energy harvesting device 10 according to an example embodiment of the present disclosure may be as follows.

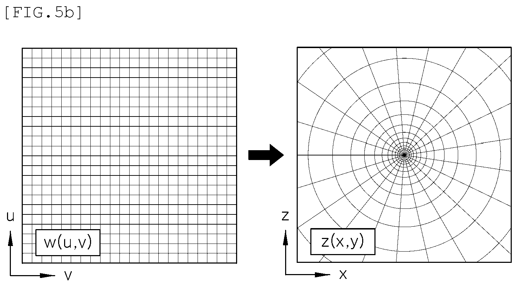

First, the elastic wave may be applied to the first area (i.e., propagation area) 200 of an object 100 in the form of the thin plate by the supply unit 20. The elastic wave may be supplied to a point P of the shear portion 201 of the propagation area 200. The elastic wave may propagate in the longitudinal direction Y through the object 100 to the rear end portion 202 of the propagation area 200. In this process, as the elastic wave moves away from the above-described point P in the propagation area 200, it takes the form of a planar wave PW, as illustrated in FIG. 5, and may reach the shear portion 301 of the focal area 300.

Next, the elastic wave energy may be concentrated (aggregated) in a partial area of the object 100. More specifically, the elastic wave energy may be concentrated on the focal point Pf within the focal area 300 using a refractive index n_{z} determined by the thickness h of the focal area 300. Here, the refractive index n_{z} is an effective refractive index and may represent a relative refractive index to a location in the focal area 300 where the refractive index n_{z} is 1. In this case, the location where the refractive index n_{z} becomes 1 in the focal area 300 is a flat portion in the focal area 300 where the thickness h does not change, for example, the two side end portions 303 and 304 of the focal area 300.

When the elastic wave propagates into the focal area 300, it may be refracted at the boundary between the propagation area 200 and the focal area 300, thereby changing the direction of propagation. This may be achieved by forming a concave part 310 to adjust the thickness h of the object 100 and implementing a refractive index distribution of a Michaelian lens in the focal area 300. In this case, the direction of refraction of the elastic wave is determined by the refractive index n_{z}, and the refractive index n_{z} may be adjusted using the thickness h of the focal area 300. For example, the refractive index n_{z} is maximum at the portion where the minimum thickness hₘᵢₙ is formed in the focal area 300, which may be a straight line area (i.e., an area where the Y-axis value is 0) that passes through the center C of the focal area 300 and extends parallel to the longitudinal direction Y.

Once the thickness h of the focal area 300 is determined, the refractive index n_{z} may be fixed regardless of the frequency of the applied elastic wave, which will be described below. Meanwhile, the rear end portion 202 of the propagation area 200 is formed at an angle from the propagation area 200 toward the focal area 300, so that the propagation area 200 and the focal area 300 may be connected in a continuous manner. As described above, the obstruction of propagation of the elastic wave due to the difference in shape between the propagation area 200 and the focal area 300 may be prevented when the elastic wave passes through the boundary therebetween.

By implementing the refractive index distribution of the Michaelian lens as described above, the elastic wave may propagate to the focal point Pf within the focal area 300 and concentrate. In this case, the focal point Pf may be a location corresponding to the focal point of the Michaelian lens.

More specifically, the focal point Pf may be a location spaced apart by a focal length Yf in the longitudinal direction Y from the above-described point P. The focal length Yf may be greater than the propagation length Y1 and shorter than the total length of the object 100. Here, the propagation length Y1 may refer to the distance from the above-described point P of the propagation area 200 to the shear portion 301 of the focal area 300. In this case, the propagation length Y1 may be equal to a length Y2 of the focal area 300.

In addition, the focal point Pf may be spaced apart from the shear portion 301 of the focal area 300 by a preset distance f. In this case, the preset distance f may refer to the distance obtained by subtracting the propagation length Y1 from the above-described focal length Yf. As the focal length Yf is determined by such a distance, the focal point Pf may be located within the concave portion 310.

Meanwhile, the implementation of the refractive index distribution of the above-described Michaelian lens may be achieved by transforming a refractive index distribution of a Maxwell fisheye lens, as illustrated in FIG. 5a, by applying conformal mapping theory with an exponential relationship. In this case, the above-described exponential relationship may be defined by the following Equation.$w \left(u, v\right) = {e}^{∧} - \frac{β}{R} z \left(x, y\right)$ Equation

In this transformation process, when the conformal mapping theory is applied to the "refractive index distribution of a Maxwell fisheye lens" in a perfect geometric form (a concentric sphere with radius R) in a virtual space as illustrated in the left of FIG. 5b, it may be transformed into a distorted form in the actual space as illustrated in the right of FIG. 5b. Accordingly, the "refractive index distribution of the Machaelian lens" as illustrated in FIG. 6 may be realized. The thickness h of the focal area 300 for realizing this refractive index distribution may be determined based on the radius R of the Maxwell fisheye lens before transformation. In this case, the relationship between the radius R of the Maxwell fisheye lens and the thickness h of the focal area 300 is defined by the following Equation (4), which will be described below.

In such a transformed Machaelian lens, as illustrated in FIG. 6, the elastic wave may be transformed into a planar wave PW as it is incident on and propagates at the point P1. Subsequently, the elastic wave is refracted as it passes through the A1 area due to the refractive index gradient of the Machaelian lens and converges at another point P2. When compared to the object 100 in which the refractive index gradient of the Machaelian lens is implemented, the A1 area of the Machaelian lens in FIG. 6 may correspond to the focal area 300 of the object 100. Furthermore, in the Machaelian lens, the point P2 where the elastic wave converges corresponds to the convergence position Pf within the focal area 300, and a length R' of the A1 area may correspond to a preset distance f of the focal area 300.

The refractive index transformation described above may be defined as shown in the following Equation (1).${n}_{z} \left(x, y\right) = {n}_{0} sech \left(\frac{βx}{R}\right)$ Equation (1)

Here, in the above Equation (1), n₀ represents the maximum refractive index in the dimension after transformation, and n_{z} represents the change in refractive index in the width direction X of the focal area 300 in the transformed actual dimension. Also, βₓ represents the conformal mapping constant, and R represents the radius of the Maxwell fisheye lens. In this case, the conformal mapping constant βₓ and the radius R of the Maxwell fisheye lens correspond to constants that can be arbitrarily set, and n₀ may be determined by setting the above-described βₓ and R.

In addition, according to the Kirchhoff-Love plate theory applied to the thin plate, a wavenumber of a first bending wave mode of the elastic wave propagating through the thin plate-shaped object 100 may be defined by the following Equation (2). $k = {\left\{\frac{12 {ρ}_{al} \left(1-{v}_{al}^{2}\right)}{{E}_{al}}\right\}}^{\frac{1}{4}} {\left(\frac{ω}{h}\right)}^{\frac{1}{2}}$ Equation (2)

Here, k is a wave vector and represents the wave number, ρₐₗ represents a density, Vₐₗ represents Poisson's ratio, Eₐₗ represents Young's modulus, and ω represents an operating frequency. Also, h is the thickness of the thin plate, and in the case of the present disclosure, represents the thickness of the focal area 300. Accordingly, in Equation (2), since the density ρₐₗ corresponds to the physical properties of the object 100, the "relationship between the wave number k and the frequency ω" may be determined by the thickness h of the focal area 300.

Referring to FIG. 7a, a band structure BS may change depending on the change in the thickness h of the focal area 300. For example, when the thickness h increases, the band structure BS may exhibit a steeper increase in slope. In this case, since the slope of the band structure BS represents a phase velocity vₚ of a wave, the relationship between the refractive index n_{z} and the thickness h of the focal area 300 may be expressed by the following Equation (3).${n}_{z}^{eff} \left(x, y\right) = \frac{{v}_{p}^{max}}{{v}_{p}} = \sqrt{\frac{{h}_{max}}{h \left(x\right)}}$ Equation (3)

Here, n_{z}^{eff} represents the effective refractive index in the transformed actual dimension, hₘₐₓ represents the maximum thickness of the above-described focal area 300, and h(x) represents the thickness according to the width of the focal area 300. Based on Equation (3), since the refractive index n_{z} is defined by the thickness h of the focal area 300, the refractive index n_{z} may be determined by adjusting only the thickness h of the focal area 300. By using the above Equation (3), the gradient (distribution) of the refractive index n_{z} according to the change in thickness h in the width direction X in the concave portion 310 of the shape described above may be calculated. The elastic waves refracted according to the refractive index gradient are concentrated on a point within the focal area 300, and this point may correspond to the above-described focal point Pf.

In addition, the thickness h of the focal area 300 may be determined using the following Equation (4), which is obtained by combining the above Equations (1) and (3). In this case, the variables included in Equation (4) have the same meaning as those previously described.$h \left(x\right) = \frac{{h}_{max}}{{\left\{{n}_{0} sech\left(\frac{βx}{R}\right)\right\}}^{2}}$ Equation (4)

Referring to FIG. 7b, it may be seen that when the thickness h of the focal area 300 is greater than or equal to a certain size, the change in the refractive index n_{z} is insignificant despite the change in the thickness h. In comparison, when the thickness h of the focal area 300 is less than or equal to a certain size, the change in the refractive index n_{z} due to the change in the thickness h is distinct. Therefore, it may be advantageous, in controlling the refractive index n_{z}, to form the focal area 300 to have a relatively small thickness h. The maximum thickness hₘₐₓ of the focal area 300 may be a value that can be arbitrarily set. Meanwhile, when the minimum thickness hₘᵢₙ is too thin, problems such as bending may occur in the focal area 300, so it is important to determine an appropriate thickness considering structural stability. For example, when the maximum thickness hₘₐₓ of the focal area 300 is 3 mm, the minimum thickness hₘᵢₙ may be 1.249 mm, but is not limited thereto.

In addition, by adjusting the thickness h of the focal area 300, the location (i.e., a focal point) Pf where the elastic wave energy is concentrated within the focal area 300 may be set. The focal point Pf may correspond to a location spaced apart by the focal length Yf of the Michaelian lens from the point P where the elastic wave of the propagation area 200 is applied. Accordingly, the focal point Pf may be determined inversely proportional to the refractive index n_{z} and proportional to the radius of curvature R of the concave portion 310 formed in the focal area 300. In this case, the "preset distance f" for determining the focal point Pf may be expressed as shown in the following Equation (5).$f = \frac{πR}{2 β}$ Equation (5)

Here, β represents the conformal mapping constant, and R may represent the radius of the Maxwell fisheye lens. These may be arbitrarily set to values necessary to determine the desired focal point Pf during the design process of the energy harvesting device 10. For example, by setting the conformal mapping constant β to 1 and the radius R of the Maxwell fisheye lens to 105 mm, the preset distance f may be designed to be approximately 164.9 mm.

As described above, based on Equations (4) and (5), the preset distance f may be determined solely by the thickness h of the concave portion 310, regardless of frequency. That is, the "focal point Pf," which is the location where the elastic wave energy is concentrated within the focal area 300, may be determined using only the thickness h of the concave portion 310. Accordingly, the focal area 300 and the object 100 including the focal area 300 may function as a wave-concentrating structure, such as a stigmatic lens, which has the same focus regardless of frequency for a first-order bending wave. Consequently, the elastic wave energy may be concentrated on the same focal point Pf even when the operating frequency is changed.

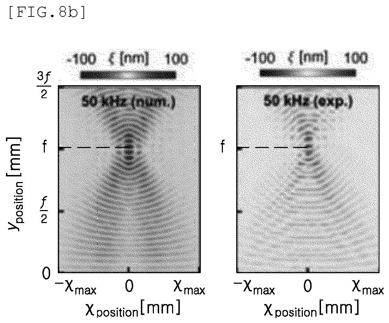

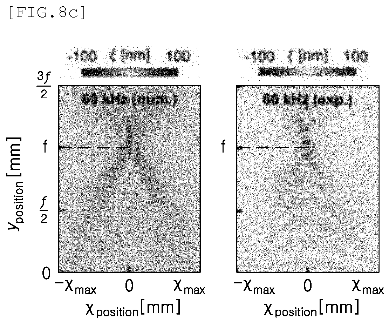

In this regard, referring to FIG. 8, FIGS. 8a, 8b, and 8c are examples showing the concentration results of the elastic wave energy when elastic waves with different frequencies are supplied, respectively. More specifically, FIG. 8A illustrates simulation results (left figure) and actual experimental results (right figure) showing that elastic wave energy is concentrated on the focal point Pf in the case of an elastic wave of 40 kHz.

FIG. 8b illustrates simulation results (left figure) and actual experimental results (right figure), showing that the elastic wave energy is concentrated on the focal point Pf in the case of an elastic wave of 50 kHz. FIG. 8c illustrates simulation results (left figure) and actual experimental results (right figure) showing that the elastic wave energy is concentrated on the focal point Pf in the case of an elastic wave of 60kHz.

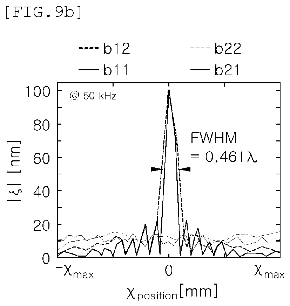

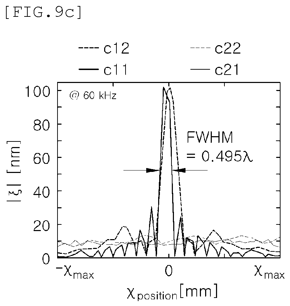

Referring to FIG. 9, FIGS. 9a, 9b, and 9c are another example showing the concentration results of the elastic wave energy when elastic waves with different frequencies are supplied, respectively. More specifically, FIG. 9a illustrates a simulation result a22 and an actual experimental result a21 showing that an elastic wave of 40 kHz propagates in the form of a planar wave to the shear portion 301 of the focal area 300, and a simulation result a12 and an actual experimental result a11 showing that the elastic wave energy passes through the shear portion 301 and converges at the focal point Pf.

FIG. 9b illustrates a simulation result b22 and an actual experimental result b21 showing that an elastic wave of 50 kHz propagates in the form of a planar wave to the shear portion 301 of the focal area 300, and a simulation result b12 and an actual experimental result b11 showing that elastic wave energy passes through the shear portion 301 and converges at the focal point Pf. FIG. 9c illustrates a simulation result c22 and an actual experimental result c21 showing that an elastic wave of 60kHz propagates in the form of a planar wave to the shear portion 301 of the focal area 300, and a simulation result b12 and an actual experimental result b11 showing that the elastic wave energy passes through the shear portion 301 and converges at the focal point Pf.

As such, as confirmed in FIGS. 8 and 9, when the thickness h of the focal area 300 is configured to be uniform, it may be confirmed that the elastic wave propagated into the focal area 300 in the form of a planar wave concentrates wave energy at the location (i.e., focal point) Pf corresponding to the same focal length, regardless of whether the frequency changes.

Next, the energy conversion unit 400 may convert elastic wave energy into electrical energy. In this case, the energy conversion unit 400 may be connected to the "focal point Pf" determined based on the thickness h of the focal area 300 as described above. Accordingly, the energy conversion unit 400 converts elastic wave energy concentrated on a focal point Pf into electrical energy, thereby allowing a higher voltage to be extracted compared to a case where the energy conversion unit 400 is connected to another location within the focal area 300, and consequently improving energy harvesting performance.

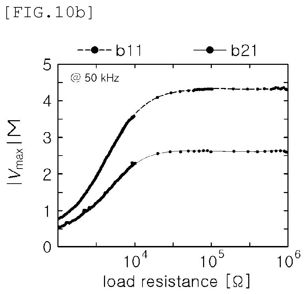

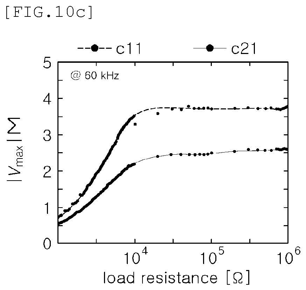

In this regard, referring to FIG. 10, FIGS. 10a, 10b, and 10c are examples showing the results of conversion into electrical energy according to the change in resistance when elastic waves having different frequencies are supplied. More specifically, FIG. 10a shows the voltage extraction result a11 at the focal point Pf and the voltage extraction result a21 at another location where wave energy is not concentrated [e.g., shear portion 301] in the case of the elastic wave of 40 kHz.

FIG. 10b illustrates the voltage extraction result b11 at the focal point Pf and the voltage extraction result b21 at another location where the wave energy is not concentrated [e.g., shear portion 301] in the case of an elastic wave of 50 kHz. Also, FIG. 10c illustrates the voltage extraction result c11 at the focal point Pf and the voltage extraction result c21 at another location where the wave energy is not concentrated [e.g., shear portion 301] in the case of a 60 kHz elastic wave.

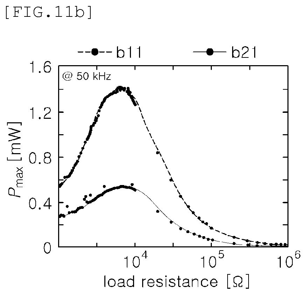

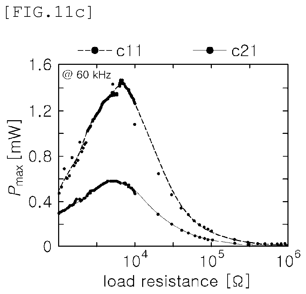

In addition, referring to FIG. 11, FIGS. 11a, 11b, and 11c are examples showing the results of conversion into electrical energy according to the change in resistance when elastic waves having different frequencies are supplied. More specifically, FIG. 11a illustrates a power measurement result a11 according to the voltage extracted at the focal point Pf and a power measurement result a21 according to the voltage extracted at another location where the wave energy is not concentrated [e.g., shear portion 301] in the case of the elastic wave of 40 kHz.

FIG. 11b illustrates a power measurement result b11 according to the voltage extracted at the focal point Pf and a power measurement result b21 according to the voltage extracted at another location where the wave energy is not concentrated [e.g., shear portion 301] in the case of the elastic wave of 50 kHz. FIG. 11c illustrates a power measurement result c11 according to the voltage extracted at the focal point Pf and a power measurement result c21 according to the voltage extracted at another location where the wave energy is not concentrated [e.g., shear portion 301] in the case of the elastic wave of 60kHz.

Referring to the voltage extraction and power measurement results in FIGS. 10 and 11 above, it may be confirmed that a higher voltage is extracted at the focal point Pf where the elastic wave energy is concentrated compared to the case where the elastic wave energy is extracted at other locations where the elastic wave energy is not concentrated.

In addition, since the power is proportional to the square of the voltage, a higher power may be measured at the focal point Pf, similar to the voltage extraction results. For example, it may be confirmed that the power measured at the focal point Pf is about 2.6 to 3.8 times higher than at other locations. Meanwhile, in the field of the energy harvesting, whether the power is 1 mW or higher serves as a criterion for determining the high performance of the device. According to the criteria, the power measured at the optimal resistance for each frequency is 1 mW or higher, confirming that the energy harvesting device 10 according to the present disclosure has the high electrical energy conversion performance.

The energy harvesting device 10 according to the example embodiments of the present disclosure, as described above, may improve energy harvesting performance by concentrating elastic wave energy at a specific location Pf within the focal area 300 to induce a high strain field in the piezoelectric element of the energy conversion unit 400.

In addition, the energy harvesting device 10 is configured such that an effective refractive index is determined only by a thickness h of the focal area 300, so that all the elastic waves are concentrated on the same focal point Pf regardless of frequency, thereby enabling implementation of piezoelectric energy harvesting not only in the high-frequency region but also in the low-frequency region. By doing so, by overcoming the disadvantages of conventional piezoelectric energy harvesting devices which are limited to the high-frequency area and by simultaneously implementing piezoelectric energy harvesting even in the low-frequency area to enable applications in real life, the piezoelectric energy harvesting device may be applied in various signal processing devices such as the Internet of Things, wireless communication, and structural safety monitoring.

Although the example embodiments of the present disclosure has been described with reference to the accompanying drawings, those skilled in the art will appreciate that various modifications and alterations may be made without departing from the spirit or essential feature of the present disclosure. Therefore, it should be understood that the above-described example embodiments are not restrictive, but are exemplary in all aspects.

### Industrial Applicability

The present disclosure may be applied to an industrially available energy harvesting device.

## Claims

1. An energy harvesting device, comprising:
an object;
a propagation area disposed in a first area of the object;
a focal area disposed in a second area of the object and having a thickness varying in a width direction of the object; and
an energy conversion unit disposed in the focal area and converting elastic wave energy into electrical energy.

2. The energy harvesting device of claim 1, wherein the propagation area is flat in shape with a uniform thickness in the width direction.

3. The energy harvesting device of claim 2, wherein the focal area has a concave portion that is concave inwardly from an upper surface of the object.

4. The energy harvesting device of claim 3, wherein the thickness gradually decreases from one end of the concave portion to the other end with respect to the width direction, and then gradually increases again.

5. The energy harvesting device of claim 4, wherein the concave portion has a shape symmetrical with respect to a center of the concave portion.

6. The energy harvesting device of claim 5, wherein the concave portion extends from one end of the focal area to the other end in a longitudinal direction of the object.

7. The energy harvesting device of claim 3, wherein the elastic wave energy is concentrated on a focal point, and
the concentration location is disposed within the concave portion, but is fixed regardless of a frequency of the elastic wave energy.

8. The energy harvesting device of claim 7, wherein the focal point is determined using an effective refractive index of the object, and
the effective refractive index is defined by the following Equation, ${n}_{z}^{eff} \left(x, y\right) = \sqrt{\frac{{h}_{max}}{h \left(x\right)}}$ wherein, in the above Equation, n_{z}^{eff} represents the effective refractive index, h(x) represents a thickness of the focal area, and hₘₐₓ represents a maximum thickness of the focal area.

9. The energy harvesting device of claim 8, wherein in the focal area, a refractive index gradient of the elastic wave energy is formed based on the change in thickness in the width direction.

10. The energy harvesting device of claim 9, wherein the refractive index gradient corresponds to a refractive index distribution of a Michaelian lens.

11. The energy harvesting device of claim 10, wherein the elastic wave energy is applied to one point on the propagation area, and
the focal point is spaced apart from the one point by a predetermined distance in the longitudinal direction of the object.

12. The energy harvesting device of claim 11, wherein the energy conversion unit includes a piezoelectric element, and
the energy conversion unit is connected to the focal point and extracts a voltage using the concentrated elastic wave energy.
